# EUROPEAN PATENT APPLICATION

(11) **EP 4 593 538 A1**
(43) Date of publication of application: **30.07.2025**
(21) Application number: 24223218.9
(22) Date of filing: 24.12.2024
(51) Int. Cl.: H05K 3/46, H04K 1/00

(54) **MULTILAYER PRINTED CIRCUIT BOARD FOR INTERCONNECTING PIN(S) AND SEMICONDUCTOR DIE(S) AND CORRESPONDING METHOD FOR INTERCONNECTION**

(30) Priority: 29.12.2023 CN 202311861348; 16.12.2024 US 202418982540
(71) Applicant: Shenzhen STS Microelectronics Co., Ltd., Shenzhen 518048 (CN)
(72) Inventor: CHEN, Qiao, Shenzhen 518040 (CN); ZHENG, Nan Nan, Shenzhen 518038 (CN); LIANG, Lin, Shenzhen 518048 (CN)
(74) Representative: Casalonga

(57) **Abstract**

A multilayer printed circuit board for interconnecting pin(s) and semiconductor die(s) is provided. A multilayer printed circuit board for interconnecting pin(s) and semiconductor die(s) comprises a multilayer substrate and pin holder(s), die contact(s), and first interconnection structure(s) embedded in the multilayer substrate. The multilayer substrate comprises a bottom substrate layer, one or more core substrate layers, and a top substrate layer stacked in sequence. and each made of an insulating material. Each of the pin holder(s) has an end exposed from a top surface of the top substrate layer for plugging the pin into the pin holder Each of the die contact(s) has an end exposed from a bottom surface of the bottom substrate layer for being electrically coupled with a contact of the semiconductor die(s) Each of the first interconnection structure(s) is connected between and electrically couples a corresponding pin holder and a corresponding die contact.

## Description

### Cross Reference to Related Application

This application is a translation of and claims the priority benefit of Chinese patent application number 202311861348.5, filed on December 29, 2023, entitled "MULTILAYER PRINTED CIRCUIT BOARD FOR INTERCONNECTING PIN(S) AND SEMICONDUCTOR DIE(S) AND CORRESPONDING METHOD FOR INTERCONNECTION," which is hereby incorporated by reference to the maximum extent allowable by law.

### Technical Field

The present disclosure relates to power module packaging, and more particularly, to a multilayer printed circuit board for interconnecting pin(s) and semiconductor die(s) in the power module packaging process and a corresponding method for interconnection.

### Background

Pin interconnection is a common interconnection mode for connecting semiconductor die(s) (especially semiconductor die(s) applied to power modules in vehicles) to a general circuit board (usually a printed circuit board), which play a very important interconnection role in a final product. However, pin(s) and pin holder(s) are one of the most fragile parts in the final product. Unlike wirings, pin(s) and pin holder(s) are very easy to be damaged, because they not only have to bear the force of being pressed/plugged in the interconnection process, but also face various situations that may occur in the welding process. The welding process of pin(s) and pin holder(s) is complicated, so various defects often occur, including, for example, solder splash, pin tilt deformation, holder deformation, holder failure, and so on.

In short, pin(s) and pin holder(s) are important and key parts for interconnecting semiconductor die(s), and any defect or failure thereof will lead to a bad influence on the final product. Therefore, it is urgent to propose an interconnection technical solution that can avoid the defects and faults of pin(s) and pin holder(s).

Therefore, the present application proposes a multilayer printed circuit board for interconnecting pin(s) and semiconductor die(s) and a corresponding method for interconnection which can solve the above problems.

### Brief Summary

One of the objects of the present disclosure is to provide an improved multilayer printed circuit board for interconnecting pin(s) and semiconductor die(s) and a corresponding method for interconnection.

According to one aspect of the present disclosure, there is provided a multilayer printed circuit board for interconnecting pin(s) and semiconductor die(s), comprising: a multilayer substrate comprising a bottom substrate layer, one or more core substrate layers, and a top substrate layer stacked in sequence, wherein each of substrate layers is made of an insulating material; pin holder(s) embedded in the multilayer substrate, each of which has an end exposed from a top surface of the top substrate layer for plugging the pin into the pin holder; die contact(s) embedded in the multilayer substrate, each of which has an end exposed from a bottom surface of the bottom substrate layer for being electrically coupled with a contact of the semiconductor die(s); and first interconnection structure(s) embedded in the multilayer substrate, each of which is connected between a corresponding pin holder and a corresponding die contact for electrically coupling both of them.

According to one or more embodiments of the present disclosure, each pin holder comprises: a tubular cavity extending in a direction perpendicular to the multilayer substrate and adapted to plug one end of a pin thereinto; and a first flange arranged at one end of the tubular cavity and protruding laterally relative to the tubular cavity, wherein the first flange is arranged on the top surface of the top substrate layer.

According to one or more embodiments of the present disclosure, the multilayer printed circuit board further comprises: auxiliary connector(s) embedded in the multilayer substrate and extending in the direction perpendicular to the multilayer substrate, each of which has one end electrically coupled to a corresponding pin holder and another end electrically connected to a corresponding die contact, wherein each of the auxiliary connector(s) comprises: a columnar body extending in the direction perpendicular to the multilayer substrate; and a second flange arranged at one end of the columnar body and protruding laterally relative to the columnar body.

According to one or more embodiments of the present disclosure, the multilayer printed circuit board further comprises: flange interconnector(s), each of which is connected between and electrically couples a second flange of a corresponding auxiliary connector and a corresponding pin holder.

According to one or more embodiments of the present disclosure, the auxiliary connector(s) comprise a first auxiliary connector, and a second flange of the first auxiliary connector and a flange interconnector connected therewith are arranged between the top substrate layer and an adjacent core substrate layer; and the flange interconnector connected with the second flange of the first auxiliary connector is also connected to a tubular cavity of a corresponding pin holder, thereby electrically coupling the corresponding pin holder with the first auxiliary connector.

According to one or more embodiments of the present disclosure, the second flange of the first auxiliary connector and the corresponding flange interconnector connected with each other are integrally formed by a same layer of metal.

According to one or more embodiments of the present disclosure, the auxiliary connector(s) comprise a second auxiliary connector, and a second flange of the second auxiliary connector and a flange interconnector connected therewith are arranged on the top surface of the top substrate layer; and the flange interconnector connected with the second flange of the second auxiliary connector is also connected to a first flange of a corresponding pin holder, thereby electrically coupling the corresponding pin holder with the second auxiliary connector.

According to one or more embodiments of the present disclosure, the second flange of the second auxiliary connector, the corresponding flange interconnector, and the first flange of the corresponding pin holder connected with each other are integrally formed by a same layer of metal.

According to one or more embodiments of the present disclosure, the multilayer printed circuit board further comprises: second interconnection structure(s) embedded in the multilayer substrate, each of which is connected between at least two die contacts for electrically coupling the at least two die contacts.

According to one or more embodiments of the present disclosure, at least a portion of the first interconnection structure(s), the second interconnection structure(s) and/or the die contact(s) are formed by a thick copper embedding process.

According to one or more embodiments of the present disclosure, the multilayer printed circuit board further comprises: buried spacer(s), each of which extends from a bottom surface of the top substrate layer through the one or more core substrate layers and the bottom substrate layer and extends beyond the bottom surface of the bottom substrate layer by a first length, wherein the first length depends on a thickness of the semiconductor die(s).

According to one or more embodiments of the present disclosure, the first length is equal to a sum of the thickness of the semiconductor die(s) and a thickness of a die attachment layer, and the die attachment layer is used for attaching the semiconductor die(s) and the multilayer printed circuit board together.

According to one or more embodiments of the present disclosure, the multilayer printed circuit board further comprises: a negative temperature coefficient contact embedded in the multilayer substrate, which is exposed from an opening arranged at center of the bottom substrate layer for coupling to a negative temperature coefficient sensor.

According to one or more embodiments of the present disclosure, the die contact(s) comprises a thick copper contact and/or a thin copper contact; and the die contact(s) is(are) used as one or more of the following: a gate-substrate contact, a source-substrate contact, a gate pad contact, and/or a source pad contact.

According to another aspect of the present disclosure, there is provided a pin, comprising: a rod-shaped body having a first end which is pointed and is adapted to be plugged into a pin holder, and a second end which comprises an elastic part and is adapted to be plugged into a through hole; and a stopper arranged at a position at a certain distance from the first end of the rod-shaped body and protruding laterally relative to the rod-shaped body, wherein the pin is adapted to be mounted in a pin holder in the multilayer printed circuit board described above, and wherein when the first end of the pin is plugged into the pin holder, the stopper leans against and on top of the first flange of the pin holder.

According to another aspect of the present disclosure, there is provided a power module, comprising: a bearing substrate; semiconductor die(s) attached onto the bearing substrate; a multilayer printed circuit board as described above, attached onto the semiconductor die(s) and electrically coupled with the semiconductor die(s) through die contact(s) of the multilayer printed circuit board; an enclosure enclosing the bearing substrate, the semiconductor die(s) and the multilayer printed circuit board; and pin(s) plugged into pin holder(s) in the multilayer printed circuit board and exposed from one side of the enclosure.

According to another aspect of the present disclosure, there is provided a method for interconnecting pin(s) and semiconductor die(s), comprising steps of: attaching the semiconductor die(s) onto a bearing substrate; attaching a multilayer printed circuit board as stated above onto the semiconductor die(s); plugging the pin(s) into pin holder(s) in the multilayer printed circuit board; and enclosing the bearing substrate, the semiconductor die(s) and the multilayer printed circuit board with an insulating material to form an enclosure.

According to another aspect of the present disclosure, there is provided a method for interconnecting pin(s) and semiconductor die(s), comprising steps of: attaching a multilayer printed circuit board as stated above onto the semiconductor die(s); attaching the semiconductor die(s) onto a bearing substrate; plugging the pin(s) into pin holder(s) in the multilayer printed circuit board; and enclosing the bearing substrate, the semiconductor die(s) and the multilayer printed circuit board with an insulating material to form an enclosure.

According to one or more embodiments of the present disclosure, attaching the multilayer printed circuit board onto the semiconductor die(s) comprises steps of: coating an attachment material on contacts of the semiconductor die(s); placing the multilayer printed circuit board on the semiconductor die(s) so that contacts of a bottom substrate layer of the multilayer printed circuit board and the contacts of the semiconductor die(s) contact each other via the attachment material; and performing a sintering process, a welding process and/or a curing process to cure the attachment material.

Other features and advantages of the present disclosure will become clearer from the following detailed description of exemplary embodiments of the present disclosure with reference to the accompanying drawings.

### Brief Description of the Drawings

The accompanying drawings, which form a portion of the specification, illustrate embodiments of the present disclosure, and together with the specification, serve to explain the principles of the present disclosure.

The present disclosure can be more clearly understood from the following detailed description with reference to the accompanying drawings, in which:
Fig. 1A schematically shows a cross-sectional view of a multilayer printed circuit board 100 for interconnecting pin(s) and semiconductor die(s) according to one or more embodiments of the present disclosure;
Figs. 1B and 1C schematically show a top view and a bottom view, respectively, of the multilayer printed circuit board 100 shown in Fig. 1A;
Fig. 2A schematically shows a front view of a pin 10 according to one or more embodiments of the present disclosure, and Fig. 2B shows a side view of the pin 10;
Fig. 3 shows a schematic size comparison between a conventional pin 20 and the pin 10 according to one or more embodiments of the present disclosure;
Fig. 4 shows an exemplary flow diagram of a method 300 for interconnecting pin(s) and semiconductor die(s) according to one or more embodiments of the present disclosure;
Figs. 5A to 5E schematically show schematic cross-sectional views of a device corresponding to a portion of steps of the method shown in Fig. 4;
Fig. 6 shows an exemplary flow diagram of another method 300' for interconnecting pin(s) and semiconductor die(s) according to one or more embodiments of the present disclosure;
Fig. 7A shows a schematic three-dimensional modeling model of a power module according to one or more embodiments of the present disclosure;
Fig. 7B shows a perspective view of a portion of parts in a multilayer printed circuit board for interconnecting pin(s) and semiconductor die(s) in the power module of Fig. 7A; and
Fig. 7C shows a bottom plan view of the multilayer printed circuit board for interconnecting pin(s) and semiconductor die(s) in the power module of Fig. 7A.

Note that in the implementations described below, sometimes the same reference is commonly used among different drawings to indicate the same part or parts with the same function, and repeated descriptions thereof are omitted. In some cases, similar reference numerals and letters are used to indicate similar items, so once an item is defined in one drawing, it does not need to be further discussed in subsequent drawings.

For the convenience of understanding, the positions, dimensions, ranges, and so on of various structures shown in the drawings sometimes do not represent the actual positions, dimensions, ranges, and so on. Therefore, the present disclosure is not limited to the positions, dimensions, ranges, and so on disclosed in the drawings, and so on.

### Detailed Description

In applications of the automobile field, the pin interconnection process will be often used when a power module including semiconductor die(s) and a general circuit board (such as a printed circuit board) are interconnected. For example, firstly, the semiconductor die(s) is(are) attached onto a bearing substrate, and pin holder(s) is(are) mounted on the bearing substrate. Next, pin(s) is(are) plugged into the pin holder(s) on the bearing substrate and welded by reflow soldering and so on. Finally, the semiconductor die(s) and the bearing substrate are enclosed with an insulating material such as epoxy resin so as to obtain a power module with pin(s) for further attachment to the general circuit board. However, the pin(s) and pin holder(s) in the power module obtained by this manufacturing process will often have various defects, such as poor contact between the pin(s) and the pin holder(s) caused by poor welding, damage or excessive inclination of the pin holder(s), solder overflow, and so on. These defects will lead to degradation of performance of the product or even unusable products, which needs to be solved urgently.

Therefore, the inventor of the present application proposes a brand-new technical solution for interconnecting pin(s) and semiconductor die(s), that is, using a dedicated multilayer printed circuit board to interconnect pin(s) and semiconductor die(s). Specifically speaking, the multilayer printed circuit board for interconnecting pin(s) and semiconductor die(s) as proposed by the present disclosure contains pin holder(s) embedded therein and contacts for being coupled to the semiconductor die(s). When it is necessary to interconnect the pin(s) and the semiconductor die(s), the multilayer printed circuit board is firstly attached onto the semiconductor die(s) through the contacts thereof, and then the pin(s) are plugged into the pin holder(s) in the multilayer printed circuit board, thus realizing the interconnection between the semiconductor die(s) and the pin(s). In addition, it is also possible to arrange other interconnection structure(s) in the multilayer printed circuit board for interconnecting pin(s) and semiconductor die(s) as proposed by the present disclosure, so that the multilayer printed circuit board can provide other interconnection functions for the semiconductor die(s).

Hereinafter, one or more detailed embodiments of the brand-new technical solution for interconnecting pin(s) and semiconductor die(s) of the present disclosure will be described in detail with reference to the accompanying drawings. It should be noted that the relative arrangements, numerical expressions and numerical values of parts and steps set forth in these embodiments do not limit the scope of the present disclosure unless otherwise specified.

The following description of at least one exemplary embodiment is merely illustrative actually and in no way brings any limitation on the present disclosure and its applications or uses. That is to say, the structures and methods herein are shown in an exemplary manner to illustrate different embodiments of the structures and methods in the present disclosure. However, those skilled in the art will understand that they merely illustrate exemplary, not exhaustive, manners for implementing the present disclosure. Furthermore, the drawings are not necessarily drawn to scale, and some features may be exaggerated to show details of specific parts.

Techniques, methods and apparatuses known to ordinary technical persons in relevant fields may not be discussed in detail, but in appropriate cases, they should be regarded as a portion of the authorized specification.

In all examples shown and discussed herein, any specific values should be interpreted as illustrative only and not as a limitation. Therefore, other examples of exemplary embodiments can have different values.

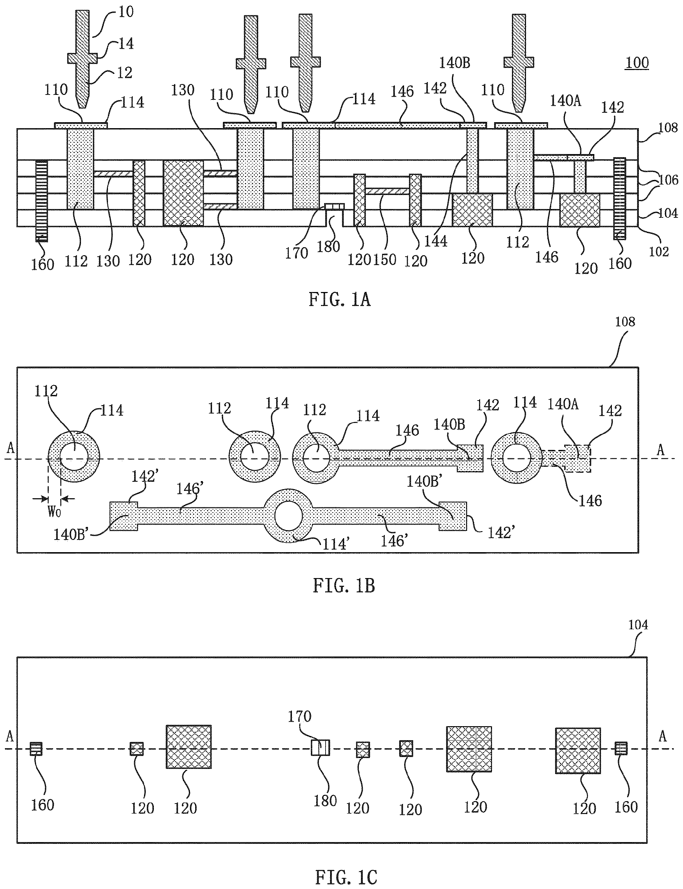

Fig. 1A schematically shows a cross-sectional view of a multilayer printed circuit board 100 for interconnecting pin(s) and semiconductor die(s) according to one or more embodiments of the present disclosure.

As shown in Fig. 1A, a multilayer printed circuit board 100 for interconnecting pin(s) and semiconductor die(s) according to one or more embodiments of the present disclosure can include a multilayer substrate 102, which is composed of a bottom substrate layer 104, one or more core substrate layers 106, and a top substrate layer 108 stacked in sequence. Each substrate layer includes an insulating material, which can include any material adapted to form insulating substrate layers of a printed circuit board, such as polyimide or epoxy resin, and so on. In addition, the materials of respective substrate layers of the multilayer substrate 102 can be the same as or different from each other.

In one or more preferred embodiments, the hardness and mechanical strength of the bottom substrate layer 104 and the top substrate layer 108 can be superior to that of the core substrate layers 106, thus providing better mechanical support for the whole multilayer printed circuit board 100.

It is understood by those skilled in the art that although Fig. 1A schematically shows three core substrate layers 106 as well as a shape, size, and thickness of each substrate layer, this is not intended to constitute any limitation. The multilayer printed circuit board 100 for interconnecting pin(s) and semiconductor die(s) according to one or more embodiments of the present disclosure can include any number of core substrate layers, and the shape, size, thickness, and material of each substrate layer can be arbitrarily set according to needs.

Figs. 1B and 1C schematically show a top view and a bottom view, respectively, of the multilayer printed circuit board 100 shown in Fig. 1A, wherein Fig. 1B shows details of the top substrate layer 108 in more detail, and Fig. 1C shows details of the bottom substrate layer 104 in more detail. The cross-sectional view of Fig. 1A is taken along line A-A in Figs. 1B and 1C.

Referring to Figs. 1A to 1C in combination, the multilayer printed circuit board 100 for interconnecting pin(s) and semiconductor die(s) according to one or more embodiments of the present disclosure can further include: pin holder(s) 110 embedded in the multilayer substrate 102. Each pin holder 110 has an end exposed from a top surface of the top substrate layer 108 for plugging the pin into the pin holder. The multilayer printed circuit board 100 according to one or more embodiments of the present disclosure can further include: die contact(s) 120 embedded in the multilayer substrate 102, and first interconnection structure(s) 130 embedded in the multilayer substrate 102. As shown in Fig. 1C, each die contact 120 has an end exposed from a bottom surface of the bottom substrate layer 104 for being electrically coupled with a contact of the semiconductor die(s). Each of the first interconnection structure(s) 130 can be connected between a corresponding pin holder 110 and a corresponding die contact 120 for electrically coupling both of them.

In the multilayer printed circuit board 100 according to one or more embodiments of the present disclosure, the pin holder(s) 110 for plugging pin(s) and the die contact(s) 120 for coupling semiconductor die(s) are embedded in the multilayer substrate 102 thereof. Besides, the pin holder(s) 110 and the die contact(s) 120 are further interconnected through the first interconnection structure(s) 130. When the multilayer printed circuit board 100 according to the present disclosure is used to interconnect the pin(s) and the semiconductor die(s), the interconnection of the pin(s) and the semiconductor die(s) can be realized by attaching the multilayer printed circuit board 100 and the semiconductor die(s) together through planar contact and then plugging the pin(s) into the pin holder(s) 110 in the multilayer printed circuit board 100. Such an interconnection solution can realize many beneficial technical effects. On one hand, compared with the prior art in which the pin holder(s) are fixed above the bearing substrate, the solution of the present disclosure embeds the pin holder(s) 110 in the multilayer substrate 102, so that the pin holder(s) 110 become more stable and difficult to tilt, thus avoiding occurrence of the problem that the pin holder(s) may be damaged during plug-in of pin(s). On the other hand, the multilayer printed circuit board 100 and the semiconductor die(s) are interconnected by means of planar contact, which can also improve the interconnection effect.

In one or more embodiments according to the present disclosure, the pin holder(s) 110 can be electrically coupled to the corresponding die contact(s) 120 through one or more first interconnection structure(s) 130. For example, as shown in Fig. 1A, the leftmost pin holder 110 in the figure is electrically coupled to the die contact 120 through one first interconnection structure 130, while another pin holder 110 adjacent the leftmost pin holder 110 is electrically coupled to the die contact 120 through two first interconnection structure(s) 130 respectively arranged between different core substrate layers.

In one or more embodiments according to the present disclosure, the first interconnection structure(s) 130 and the die contact(s) 120 can be formed by various processes known in the art for manufacturing conductive parts in the printed circuit board, for example, they can be formed by thin copper layers arranged between various substrate layers or by thick copper blocks embedded in the substrate layers by a thick copper embedding (also called Cu In-lay) process.

In one or more embodiments according to the present disclosure, the die contact 120 can include a thick copper contact and/or a thin copper contact, wherein the thick copper contact can be used as a source contact that needs to conduct a larger current, for example, and the thin copper contact can be used as a gate contact that needs to conduct a smaller current, for example. In one or more preferred embodiments, the die contact 120 can be used as one or more of the following: a gate-substrate contact, a source-substrate contact, a gate pad contact, and/or a source pad contact, and so on.

It is understood by those skilled in the art that although the numbers, distributions, shapes, and sizes of the pin holder(s) 110, the die contact(s) 120 and the corresponding first interconnection structure(s) 130 are shown in Figs. 1A to 1C, this is not intended to constitute any limitation. The multilayer printed circuit board 100 according to one or more embodiments of the present disclosure can include pin holder(s) 110, die contact(s) 120 and/or first interconnection structure(s) 130 of any numbers, any distributions, any shapes, and any sizes. In addition, the die contact(s) 120 and the first interconnection structure(s) 130 according to one or more embodiments of the present disclosure are not limited to being made of copper, but can include any material suitable for forming conductive contacts.

With continued reference to Figs. 1A and 1B, in one or more embodiments according to the present disclosure, each pin holder 110 can include a tubular cavity 112 and a first flange 114. The tubular cavity 112 can extend in a direction perpendicular to the multilayer substrate 102 and is adapted to plug one end of the pin 10 thereinto. The first flange 114 can be arranged at one end of the tubular cavity 112 and protrude laterally relative to the tubular cavity 112. As shown in Fig. 1A, the first flange 114 is arranged on a top surface of the top substrate layer 108 to serve as the end of the pin holder 110 that is exposed from the top surface of the top substrate layer 108. In order to be adapted to plug the pin 10 into the pin holder, an inner diameter of the tubular cavity 112 of the pin holder 110 matches a diameter of the plug-in end of the pin 10, and the first flange 114 can be formed into an annular shape with an inner diameter consistent with the inner diameter of the tubular cavity 112 and with an outer diameter larger than the inner diameter, as clearly shown in Fig. 1B.

In the one or more embodiments according to the present disclosure, the pin holder 110 can be more firmly supported in the multilayer substrate 102 with the aid of the interaction between the first flange 114 and the top substrate layer 108 by arranging the first flange 114 at one end of the tubular cavity 112 of the pin holder 110.

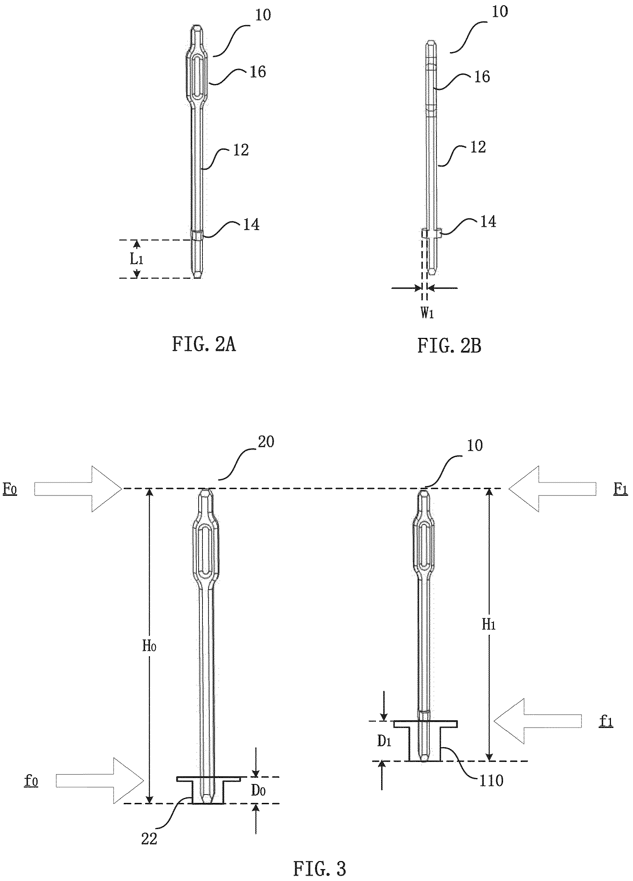

Fig. 2A schematically shows a front view of a pin 10 according to one or more embodiments of the present disclosure, which is adaptive for a pin holder 110 in the multilayer printed circuit board 100 according to one or more embodiments of the present disclosure. Fig. 2B shows a side view of the pin 10.

As shown in Figs. 2A and 2B, the pin 10 according to one or more embodiments of the present disclosure can include an elongated rod-shaped body 12. A first end of the rod-shaped body 12 is pointed and is adapted to be plugged into the pin holder 110, and a second end thereof includes an elastic part 16 and is adapted to be stuck into a through hole, which includes, for example, a through hole arranged in a general circuit board (such as a printed circuit board) to which the pin is to be connected. The pin 10 can further include a stopper 14, which is arranged at a position at a certain distance L1 from the first end of the rod-shaped body 12 and protrudes laterally relative to the rod-shaped body 12. The distance L1 of the stopper 14 from the first end of the rod-shaped body 12 can depend on the height of the pin holder. In one or more preferred embodiments, the distance L1 of the stopper 14 from the first end of the rod-shaped body 12 can be the same as or slightly smaller than the height of the pin holder. In one or more preferred embodiments, the stopper 14 can include two semi-cylindrical protrusions oppositely arranged on two opposite sides of the rod-shaped body 12, and the radius W1 of such semi-cylindrical protrusions can depend on the size of the flange of the pin holder, for example, it can be equal to or slightly smaller than the width W0 of the annular flange of the pin holder (as shown in Fig. 1B).

In one or more embodiments according to the present disclosure, when the first end of the pin 10 is plugged into the pin holder 110, the stopper 14 of the pin 10 can lean against and on top of the first flange 114 of the pin holder 110. On one hand, the mutual leaning between the stopper 14 of the pin 10 and the first flange 114 of the pin holder 110 can provide more mechanical support for the pin 10, which will be discussed in more detail later, and cause the pin 10 to be more firmly plugged. On the other hand, the stopper 14 of the pin 10 can also prevent the pin 10 from being plugged too deeply in the pin holder and ensure that the pin 10 is plugged at an appropriate depth.

Fig. 3 shows a schematic size comparison between a conventional pin 20 and the pin 10 according to one or more embodiments of the present disclosure.

As mentioned above, the existing technologies for pin interconnection arrange the pin holder(s) on the bearing substrate. However, in one or more embodiments of the present application, the pin holder(s) are arranged in a multilayer printed circuit board attached onto the semiconductor die(s). Therefore, on the premise that the whole thickness of the power module remains unchanged, the presence of the multilayer printed circuit board according to one or more embodiments of the present disclosure enables the height of the pin holder(s) to be higher and the pin(s) to be shorter, and these changes can also improve the effect of pin interconnection.

As shown in Fig. 3, a height H1 of the pin 10 according to one or more embodiments of the present disclosure can be smaller than a height H0 of the conventional pin 20. In one or more preferred embodiments, the height H1 of the pin 10 according to one or more embodiments of the present disclosure can be about 1.3mm smaller than the height H0 of the conventional pin 20. This is because a thickness of the bottom substrate layer of the multilayer printed circuit board can be about 1mm, and a total thickness of the semiconductor die(s) and the die attachment layer for attaching the semiconductor die(s) to the multilayer printed circuit board can be about 0.3mm. Therefore, the height H1 of the pin 10 according to one or more embodiments of the present disclosure can be reduced by about 1mm+0.3mm=1.3mm relative to the conventional pin.

With continued reference to Fig. 3, a conventional pin holder 22 into which the conventional pin 20 is plugged, and the pin holder 110 according to one or more embodiments of the present disclosure, into which the pin 10 according to one or more embodiments of the present disclosure is plugged, are also schematically shown, wherein the height of the pin holder 22 is D0 and the height of the pin holder 110 is D1. When the pin 10 is plugged into the pin holder 110, if the top end of the pin 10 is subjected to a lateral acting force F1, the part of the pin 10 plugged into the pin holder 110 will be subjected to a corresponding acting force f1. It is expected that the acting force f1 should be as small as possible to prevent the pin from being damaged. The acting force f1 that the part of the pin 10 plugged into the pin holder 110 is subject to satisfies the formula: F1*(H1-D1)=f1*D1, where H1 is the height of the pin 10 and D1 is the height of the pin holder 110. From this formula, it can be known that the smaller the height of the pin and the larger the height of the pin holder, the smaller the corresponding acting force f1 exerted on the part of the pin plugged into the pin holder when the top end of the pin is subjected to a lateral acting force. For example, the traditional pin 20 has a height H0=14.8 mm, and the corresponding pin holder 22 has a height D0=2.8 mm, then the plug-in part of the pin 20 is subject to the acting force f0 = F0 * (H0-D0)/D0 = F0 * (14.8-2.8)/2.8 ≈ 4.29F0. In contrast, the pin 10 according to the present disclosure has a height H1=13.5 mm, and the corresponding pin holder 110 has a height D0=4.5 mm. Based on the above formula, the plug-in part of the pin 10 is subject to the acting force f1=F1 * (13.5-4.5)/4.5 ≈ 2.22F1, which is about 51.7% less than that of the traditional pin.

Returning to Figs. 1A to 1C, the multilayer printed circuit board 100 for interconnecting pin(s) and semiconductor die(s) according to one or more embodiments of the present disclosure can further include auxiliary connector(s) 140A/140B embedded in the multilayer substrate 102 and extending in a direction perpendicular to the multilayer substrate 102. Each auxiliary connector has one end electrically coupled to the corresponding pin holder 110 and another end electrically connected to the corresponding die contact 120.

In one or more embodiments according to the present disclosure, as shown in Fig. 1A, each auxiliary connector 140A/140B may include a columnar body 144 and a second flange 142 arranged at one end of the columnar body 144. The columnar body 144 can extend in the direction perpendicular to the multilayer substrate 102 to be connected to the die contact 120. The second flange 142 protrudes laterally relative to the columnar body 144.

As shown in Figs. 1A and 1B, the multilayer printed circuit board 100 according to one or more embodiments of the present disclosure can further include flange interconnector(s) 146, each of which can be connected between a second flange 142 of a corresponding auxiliary connector 140A/140B and a corresponding pin holder 110, thereby electrically coupling the corresponding auxiliary connector 140A/140B with the corresponding pin holder 110.

In one or more embodiments according to the present disclosure, the auxiliary connector(s) can include a first auxiliary connector 140A, and the second flange 142 of the first auxiliary connector 140A and a flange interconnector 146 connected therewith are arranged between the top substrate layer 108 and an adjacent core substrate layer 106. The flange interconnector 146 connected with the second flange 142 of the first auxiliary connector 140A can also be connected to a tubular cavity 112 of a corresponding pin holder 110, thereby electrically coupling the corresponding pin holder 110 with the first auxiliary connector 140A.

Since the flange interconnector 146 connected with the second flange 142 of the first auxiliary connector 140A is arranged below the top substrate layer 108, the flange interconnector 146 cannot be seen originally in the top view of the top substrate layer 108 shown in Fig. 1B. However, in order to clearly show its shape, the flange interconnector 146 in a perspective state is shown in the top view of Fig. 1B by a dotted line.

In one or more preferred embodiments, the second flange 142 of the first auxiliary connector 140A and the corresponding flange interconnector 146 connected with each other can be integrally formed by the same layer of metal.

In one or more embodiments according to the present disclosure, the auxiliary connector(s) can include a second auxiliary connector 140B, and a second flange 142 of the second auxiliary connector 140B and a flange interconnector 146 connected therewith are arranged on the top surface of the top substrate layer 108. The flange interconnector 146 connected with the second flange 142 of the second auxiliary connector 140B can also be connected to a first flange 114 of a corresponding pin holder 110, thereby electrically coupling the corresponding pin holder 110 with the second auxiliary connector 140B.

In one or more preferred embodiments, the second flange 142 of the second auxiliary connector 140B, the corresponding flange interconnector 146, and the first flange 114 of the corresponding pin holder 110 connected with each other are integrally formed by the same layer of metal.

In one or more embodiments according to the present disclosure, a first flange of one pin holder can be connected to a plurality of second flanges of a plurality of auxiliary connectors through a plurality of flange interconnectors, respectively. As shown in Fig. 1B, a first flange 114' of the pin holder is connected to two second flanges 142' of two auxiliary connectors 140B' through two flange interconnectors 146' extending in opposite directions, respectively, so that the pin holder can be electrically connected to at least two auxiliary connectors 140B' and then electrically coupled to at least two die contacts.

It is understood by those skilled in the art that although the first auxiliary connector 140A and the second auxiliary connector 140B are shown in Figs. 1A to 1C, this is not intended to constitute any limitation. The multilayer printed circuit board 100 according to one or more embodiments of the present disclosure can include only the first auxiliary connector(s) 140A, only the second auxiliary connector(s) 140B, or both the first auxiliary connector(s) 140A and the second auxiliary connector(s) 140B.

In one or more embodiments according to the present disclosure, the pin holder 110 can be electrically coupled with the die contact either through the first interconnection structure, or through the flange interconnector and the auxiliary connector. This provides great flexibility for the interconnection design of the multilayer printed circuit board, so that various and different interconnection structures can be flexibly arranged in the multilayer printed circuit board according to needs of the applications, the area and space can be fully used, and the hardware consumption can be reduced.

With continued reference to Figs. 1A and 1B, in one or more embodiments according to the present disclosure, the multilayer printed circuit board 100 can further include second interconnection structure(s) 150 embedded in the multilayer substrate 102. Each second interconnection structure 150 can be connected between at least two die contacts 120 for electrically coupling these die contacts together. The second interconnection structure(s) 150 can be formed by various processes known in the art for manufacturing conductive parts in the printed circuit board, for example, it(they) can be formed by thin copper layers arranged between various substrate layers, or by thick copper blocks embedded in the substrate layers through a thick copper embedding (also called Cu In-lay) process.

In one or more preferred embodiments, at least a portion of the first interconnection structure(s) 130, the second interconnection structure(s) 150 and/or the die contact(s) 120 according to one or more embodiments of the present disclosure are formed by a thick copper embedding process.

In the multilayer printed circuit board 100 according to one or more embodiments of the present disclosure, in addition to the connection structures (e.g., the first interconnection structure(s) 130, the auxiliary connector(s) 140A/140B, the flange connectors 146, and so on.) for connecting the pin holder(s) 110 and the die contact(s) 120, interconnection structures (e.g., the second interconnection structure(s) 150) for realizing the connections between the various die contacts 120 can also be included. The second interconnection structure(s) 150 enable interconnections of the various contacts of the semiconductor die(s) to be attached without pin(s) through the multilayer printed circuit board 100. It makes one more possible connection mode between the various contacts of the semiconductor die(s), thus bringing more possibilities for the design of the whole power module.

It is understood by those skilled in the art that although the numbers, distributions, shapes, and sizes of the auxiliary connector(s) 140A/140B, the flange interconnector(s) 146 and the second interconnection structure(s) 150 are shown in Figs. 1A to 1C, this is not intended to constitute any limitation. The multilayer printed circuit board 100 according to one or more embodiments of the present disclosure can include auxiliary connector(s) 140A/140B, flange interconnector(s) 146 and/or second interconnection structure(s) 150 and so on of any numbers, any distributions, any shapes, and any sizes. In addition, the flange interconnector(s) 146 and the second interconnection structure(s) 150 according to one or more embodiments of the present disclosure are not limited to being made of copper, but can include any material suitable for forming conductive parts.

With continued reference to Figs. 1A to 1C, the multilayer printed circuit board 100 according to one or more embodiments of the present disclosure can optionally include buried spacer(s) 160, which are arranged at idle positions in the multilayer substrate 102 where no other conductive parts are arranged, and are made of an insulating material with a certain mechanical strength for enhancing the mechanical support for the multilayer printed circuit board 100. As shown in Fig. 1A, each buried spacer 160 extends from a bottom surface of the top substrate layer 108 through the core substrate layer(s) 106 and the bottom substrate layer 104, and extends beyond the bottom surface of the bottom substrate layer 104 by a first length, and the first length can depend on the thickness of the semiconductor die(s) to which the multilayer printed circuit board 100 is to be attached.

In one or more preferred embodiments, when the multilayer printed circuit board 100 is attached onto the semiconductor die(s), one end of each buried spacer 160 beyond the bottom substrate layer 104 leans against and on top of the supporting structure for supporting the semiconductor die(s) so as to enhance the mechanical support for the multilayer printed circuit board 100. Therefore, the first length of the buried spacer 160 beyond the bottom substrate layer 104 can be equal to or slightly greater than a sum of the thickness of the semiconductor die(s) and the thickness of a die attachment layer, and the die attachment layer refers to a material layer for attaching the semiconductor die(s) and the multilayer printed circuit board together.

With continued reference to Figs. 1A to 1C, the multilayer printed circuit board 100 according to one or more embodiments of the present disclosure can further optionally include a negative temperature coefficient (NTC) contact 170 embedded in the multilayer substrate 102. The negative temperature coefficient contact 170 can be exposed from an opening 180 arranged at the center of the bottom substrate layer 104 for being coupled to a negative temperature coefficient sensor. A temperature sensor can be arranged in the opening 180 for detecting the temperature of the power module.

It is understood by those skilled in the art that although the numbers, distributions, shapes, and sizes of the buried spacer(s) 160, the negative temperature coefficient contacts 170, and so on are shown in Figs. 1A to 1C, this is not intended to constitute any limitation. The multilayer printed circuit board 100 according to one or more embodiments of the present disclosure can include buried spacer(s) 160, negative temperature coefficient contact(s) 170 and so on of any numbers, any distributions, any shapes, and any sizes.

It is understood by those skilled in the art that although the multilayer printed circuit board 100 shown in Figs. 1A to 1C includes various parts, this is only to show the various parts as comprehensively as possible in the same set of drawings, and is not intended to constitute any limitation. The multilayer printed circuit board 100 according to one or more embodiments of the present disclosure can include only a portion of various parts shown in Figs. 1A to 1C. In addition, the numbers, distributions, shapes, and sizes of various parts shown in Figs. 1A to 1C are only used for illustration and are not intended to constitute any limitation. The multilayer printed circuit board 100 according to one or more embodiments of the present disclosure can include the above parts of any number, any distribution, any shape, and any size.

It should also be understood by those skilled in the art that although various parts are included in the same cross-sectional view in Fig. 1A, this is only to show various parts as comprehensively as possible in the same drawing, and is not intended to constitute any limitation. A plurality of different parts of the multilayer printed circuit board 100 according to one or more embodiments of the present disclosure may not occur in the same cross-sectional view, so the cross-sectional view of the multilayer printed circuit board 100 can include only a portion of the parts shown in Fig. 1A.

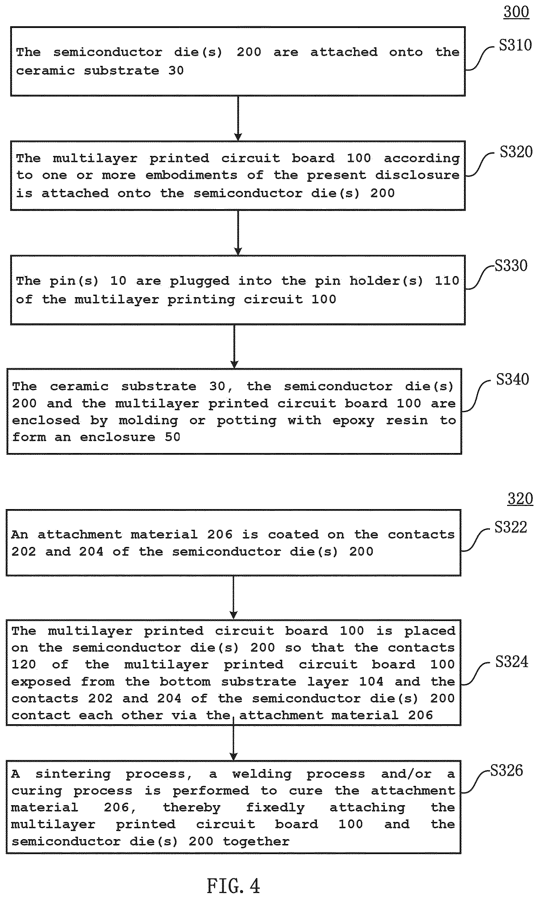

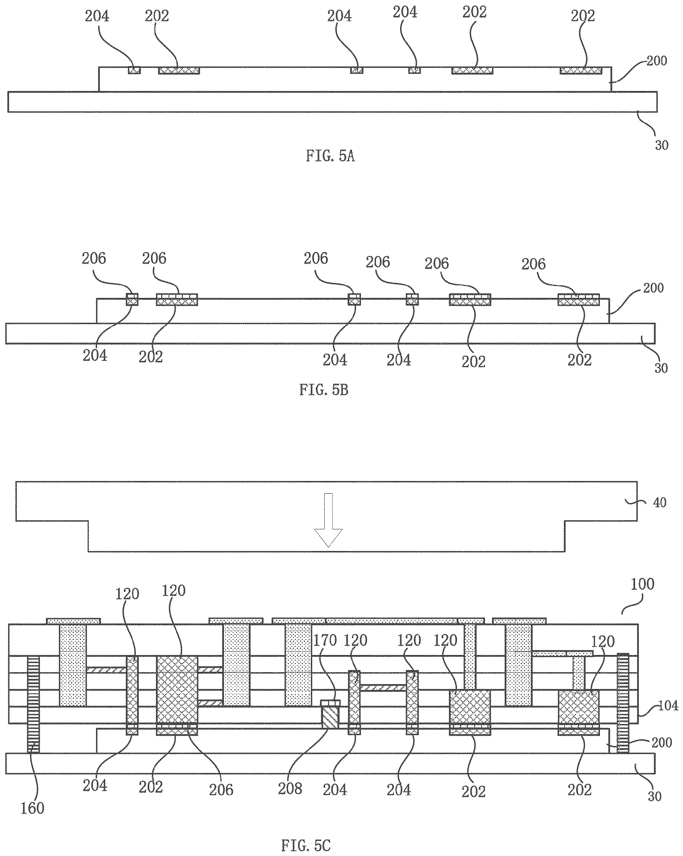

A method for interconnecting pin(s) and semiconductor die(s) according to one or more embodiments of the present disclosure is described below with reference to Fig. 4 and Figs. 5A to 5E. Fig. 4 shows an exemplary flow diagram of the method for interconnecting pin(s) and semiconductor die(s) according to one or more embodiments of the present disclosure, and Figs. 5A to 5E schematically show schematic cross-sectional views of a device corresponding to a portion of steps of the method shown in Fig. 4. Those skilled in the art will understand that the method for interconnecting pin(s) and semiconductor die(s) described in connection with Fig. 4 and Figs.5A to 5E uses the multilayer printed circuit board according to one or more embodiments of the present disclosure for interconnection, so the corresponding description of the multilayer printed circuit board mentioned above also applies here.

As shown in Fig. 4, a method 300 for interconnecting pin(s) and semiconductor die(s) according to one or more embodiments of the present disclosure can include steps S310, S320, S330 and S340.

At step S310, as shown in Fig. 5A, the semiconductor die(s) 200 is(are) attached onto the bearing substrate 30. In one or more embodiments according to the present disclosure, the bearing substrate 30 can be a ceramic substrate covered with copper, such as a direct bonded copper (DBC) ceramic substrate or an active metal brazing (AMB) ceramic substrate, or any other type of bearing substrate.

In one or more embodiments according to the present disclosure, the semiconductor die(s) 200 can include a plurality of contacts 202 and 204. In one or more preferred embodiments, the contact(s) 204 with a smaller area can include a gate contact, and the contact(s) 202 with a larger area can include a source contact.

It is understood by those skilled in the art that although the numbers, distributions, shapes, and sizes of the contacts of the semiconductor die(s) 200 are schematically shown in Fig.5A, this is not intended to constitute any limitation. The semiconductor die(s) 200 according to one or more embodiments of the present disclosure can include contacts of any number, any distribution, any shape, and any size.

At step S320, the multilayer printed circuit board 100 according to one or more embodiments of the present disclosure is attached onto the semiconductor die(s) 200.

In one or more embodiments according to the present disclosure, attaching the multilayer printed circuit board 100 to the semiconductor die(s) 200 can be realized through steps S322, S324 and S326 described below.

At step S322, as shown in Fig. 5B, an attachment material 206 is coated on the contacts 202 and 204 of the semiconductor die(s) 200. The attachment material 206 can include, for example, sinter, solder, gel, and the like.

At step S324, as shown in Fig. 5C, the multilayer printed circuit board 100 is placed on the semiconductor die(s) 200 so that the contacts 120 of the multilayer printed circuit board 100 exposed from the bottom substrate layer 104 and the contacts 202 and 204 of the semiconductor die(s) 200 contact each other via the attachment material 206.

In one or more preferred embodiments, the negative temperature coefficient contact 170 can be coupled to a negative temperature coefficient sensor 208.

In one or more preferred embodiments, one end of each buried spacer 160 in the multilayer printed circuit board 100 protruding from the bottom substrate layer 104 leans against and on top of the bearing substrate 30 below the semiconductor die(s) 200, thereby providing better mechanical support for the multilayer printed circuit board 100.

At step S326, a sintering process, a welding process and/or a curing process is performed to cure the attachment material 206, thereby fixedly attaching the multilayer printed circuit board 100 and the semiconductor die(s) 200 together. In one or more preferred embodiments, as shown in Fig. 5C, a sintering tool 40 can be used to press the printed circuit board 200 against the semiconductor die(s) 200, thereby improving the strength of attachment.

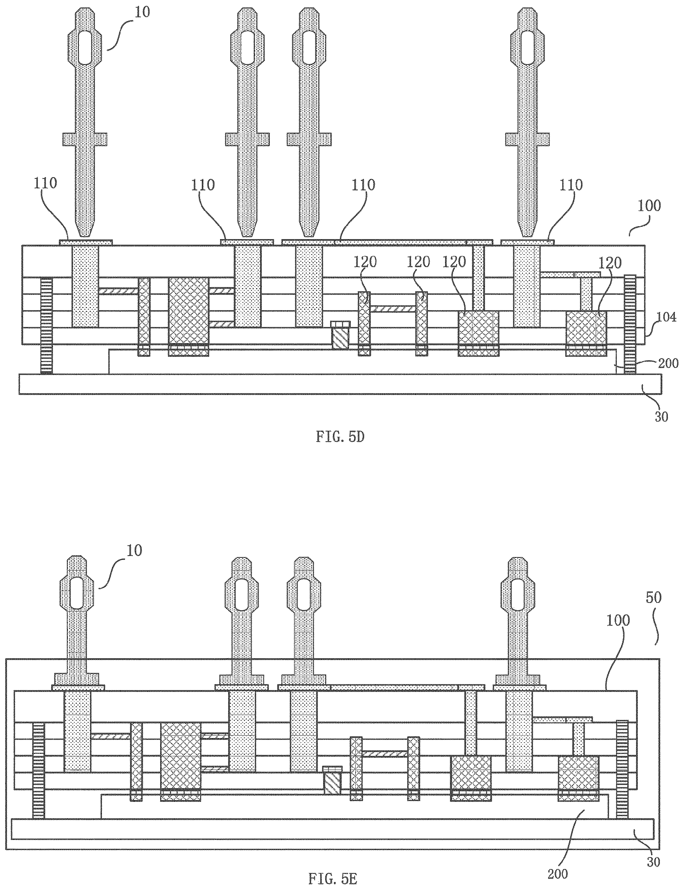

With continued reference to Fig. 4, at step S330, the pin(s) 10 are plugged into the pin holder(s) 110 of the multilayer printing circuit 100, as shown in Fig. 5D.

At step S340, as shown in Fig. 5E, the bearing substrate 30, the semiconductor die(s) 200 and the multilayer printed circuit board 100 are enclosed by molding or potting with epoxy resin to form an enclosure 50, thereby obtaining a packaged power module.

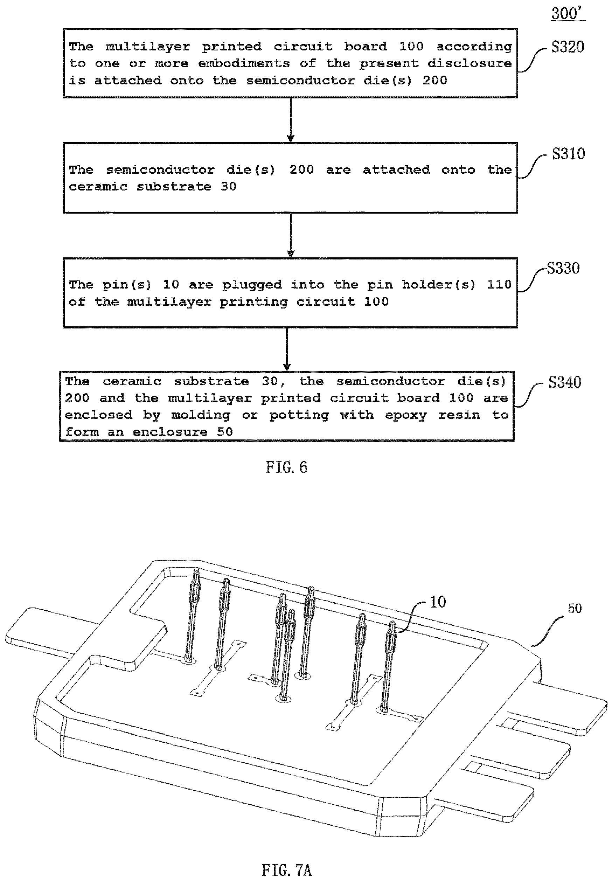

The execution sequence of steps S310 and S320 of the method 300 for interconnecting pin(s) and semiconductor die(s) shown in Fig. 4 can be interchanged. Fig. 6 shows another method 300' for interconnecting pin(s) and semiconductor die(s) according to one or more embodiments of the present disclosure, which is a modified embodiment of the method 300 for interconnecting pin(s) and semiconductor die(s) shown in Fig. 4. Compared with the method 300 in Fig. 4, a main difference of the method 300' shown in Fig. 6 is that step S320 is executed first, and then step S310 is executed. Except the execution sequence of the steps is different, all the contents described above about the method 300 in Fig. 4 can be applied to the corresponding features of the method 300' shown in Fig. 6.

As shown in Fig. 6, the method 300' for interconnecting pin(s) and semiconductor die(s) according to one or more embodiments of the present disclosure can include steps S320, S310, S330 and S340.

At step S320, the multilayer printed circuit board 100 according to one or more embodiments of the present disclosure is attached onto the semiconductor die(s) 200.

At step S310, the semiconductor die(s) 200 are attached onto the bearing substrate 30.

At step S330, the pin(s) 10 are plugged into the pin holder(s) 110 of the multilayer printing circuit 100.

At step S340, the bearing substrate 30, the semiconductor die(s) 200 and the multilayer printed circuit board 100 are enclosed by molding or potting with epoxy resin to form an enclosure 50, thereby obtaining a packaged power module.

Fig. 5E schematically illustrates a power module according to one or more embodiments of the present disclosure, which can be manufactured, for example, by the method 300 for interconnecting pin(s) and semiconductor die(s) shown in Fig. 4 or by the method 300' for interconnecting pin(s) and semiconductor die(s) shown in Fig. 6.

As shown in Fig. 5E, the power module can include: a bearing substrate 30; semiconductor die(s) 200 arranged on the bearing substrate 30; a multilayer printed circuit board 100 according to one or more embodiments of the present disclosure, arranged on semiconductor die(s) 200 and electrically coupled with the semiconductor die(s) 200 through die contact(s) thereof; an enclosure 50 enclosing the bearing substrate 30, the semiconductor die(s) 200 and the multilayer printed circuit board 100; and pin(s) 10 plugged into pin holder(s) in the multilayer printed circuit board 100 and exposed from one side of the enclosure 50.

Fig. 7A shows a schematic three-dimensional modeling model of the power module according to one or more embodiments of the present disclosure. Referring to Fig. 7A, a packaged power module is shown, in which the pin(s) 10 are exposed from one side of the enclosure 50 for being further coupled to a general circuit board.

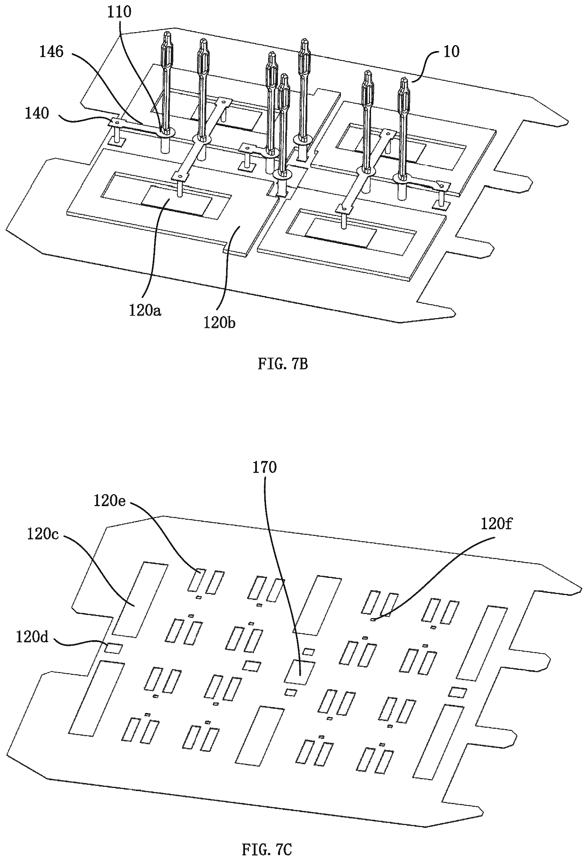

Fig. 7B shows a perspective view of a portion of parts in the multilayer printed circuit board for interconnecting pin(s) and semiconductor die(s) in the power module of Fig. 7A. Referring to Fig. 7B, the pin(s) 10, the pin holder(s) 110, the auxiliary connector(s) 140 and the flange interconnector(s) 146 are shown, and the gate contacts 120a and the source contacts 120b serving as die contact(s) are also shown.

Fig. 7C shows a bottom plan view of the multilayer printed circuit board for interconnecting pin(s) and semiconductor die(s) in the power module of Fig. 7A. As shown in Fig. 7C, the multilayer printed circuit board according to one or more embodiments of the present disclosure includes source-substrate contacts 120c, gate-substrate contacts 120d, source pad contacts 120e and gate pad contacts 120f, which are exposed from the bottom substrate layer thereof and serve as the die contact(s), as well as a negative temperature coefficient contact 170 exposed from the opening of the bottom substrate layer.

It is understood by those skilled in the art that the above modeling model shown in Figs. 7A to 7C is only for the convenience of those skilled in the art to better understand the technical concept of the present disclosure, and are not intended to constitute any limitations.

The words "front", "back", "top", "bottom", "above" and "below" in the specification and claims, if any, are used for descriptive purposes and not necessarily for describing the constant relative positions. It should be understood that the words so used are interchangeable under appropriate circumstances, so that the one or more embodiments of the disclosure described herein are, for example, capable of operation in other orientations than those orientations shown or otherwise described herein.

As used herein, the word "exemplary" means "serving as an example, instance or illustration", not as a "model" to be accurately reproduced. Any implementation exemplarily described herein is not necessarily to be construed as preferred or advantageous over other implementations. Moreover, the present disclosure is not limited by any expressed or implied theory given in the above technical field, background, summary or detailed description.

As used herein, the word "substantially" is meant to contain any slight changes caused by defects of design or manufacture, tolerances of devices or elements, environmental influences and/or other factors. The word "substantially" also allows for differences between perfect or ideal circumstances caused by parasitic effects, noise and other practical considerations that may exist in actual implementations.

In addition, the foregoing description may refer to elements or nodes or features that are "connected" or "coupled" together. As used herein, "connected" means that one element/node/feature is electrically, mechanically, logically or otherwise directly connected (or in direct communication) with another element/node/feature, unless explicitly stated otherwise. Similarly, "coupled" means that one element/node/feature can be mechanically, electrically, logically or otherwise connected with another element/node/feature in a direct or indirect way to allow interaction, even though the two features may not be directly connected, unless explicitly stated otherwise. That is, "coupled" is intended to contain direct and indirect connection of elements or other features, including connection with one or more intervening elements.

In addition, similar terms such as "first" and "second" can also be used herein for reference purposes only, and thus are not intended to be limiting. For example, the words "first", "second" and other such numerical words involving structures or elements do not imply an order or sequence, unless the context clearly indicates.

It should also be understood that the term "including/include/comprising/comprise/containing/contain" when used herein is used to specify the presence of the indicated features, integers, steps, operations, units and/or components, but does not exclude the presence or addition of one or more other features, integers, steps, operations, units and/or components and/or combinations thereof.

In the present disclosure, the term "providing/provide" is used broadly to cover all ways of obtaining an object, so "providing an object" includes but is not limited to "purchasing", "preparing / manufacturing", "arranging / disposing", "installing / assembling", and/or "ordering" an object, and so on.

Those skilled in the art should realize that the boundaries between the above operations are merely illustrative. Multiple operations can be combined into a single operation, a single operation can be distributed among additional operations, and the operations can be performed at least partially overlapping in time. Moreover, alternative embodiments can include multiple instances of specific operations, and the sequence of operations can be changed in other various embodiments. However, other modifications, variations and substitutions are also possible. Therefore, the Specification and Drawings should be regarded as illustrative rather than restrictive.

Although some specific embodiments of the present disclosure have been described in detail through examples, it should be understood by those skilled in the art that the above examples are only for illustration and are not intended to limit the scope of the present disclosure. The one or more embodiments disclosed herein can be arbitrarily combined without departing from the spirit and scope of the present disclosure. Those skilled in the art will also understand that various modifications can be made to the one or more embodiments without departing from the scope and spirit of the present disclosure. The scope of the present disclosure is defined by the appended claims.

## Claims

1. A multilayer printed circuit board for interconnecting one or more pins and one or more semiconductor dies comprising:
a multilayer substrate comprising a bottom substrate layer, one or more core substrate layers, and a top substrate layer stacked in sequence, wherein each of substrate layers is made of an insulating material;
one or more pin holders embedded in the multilayer substrate, each of which has an end exposed from a top surface of the top substrate layer for plugging the one or more pins into the one or more pin holders;
one or more die contacts embedded in the multilayer substrate, each of which has an end exposed from a bottom surface of the bottom substrate layer for being electrically coupled with a contact of the one or more semiconductor dies; and
one or more first interconnection structures embedded in the multilayer substrate, each of which is connected between and electrically couples a corresponding pin holder and a corresponding die contact.

2. The multilayer printed circuit board according to Claim 1, wherein each pin holder comprises:
a tubular cavity extending in a direction perpendicular to the multilayer substrate and adapted to plug one end of a pin thereinto; and
a first flange arranged at one end of the tubular cavity and protruding laterally relative to the tubular cavity, wherein the first flange is arranged on the top surface of the top substrate layer.

3. The multilayer printed circuit board according to Claim 2, further comprising:
one or more auxiliary connectors embedded in the multilayer substrate and extending in the direction perpendicular to the multilayer substrate, each of which has one end electrically coupled to a corresponding pin holder and another end electrically connected to a corresponding die contact;
wherein each of the one or more auxiliary connectors comprises:
a columnar body extending in the direction perpendicular to the multilayer substrate; and
a second flange arranged at one end of the columnar body and protruding laterally relative to the columnar body.

4. The multilayer printed circuit board according to Claim 3, further comprising:
one or more flange interconnectors, each of which is connected between and electrically couples a second flange of a corresponding auxiliary connector and a corresponding pin holder.

5. The multilayer printed circuit board according to Claim 4, wherein the one or more auxiliary connectors comprise a first auxiliary connector, and a second flange of the first auxiliary connector and a flange interconnector connected therewith are arranged between the top substrate layer and an adjacent core substrate layer; and
wherein the flange interconnector connected with the second flange of the first auxiliary connector is also connected to a tubular cavity of a corresponding pin holder, thereby electrically coupling the corresponding pin holder with the first auxiliary connector.

6. The multilayer printed circuit board according to Claim 5, wherein the second flange of the first auxiliary connector and a corresponding flange interconnector connected with each other are integrally formed by a same layer of metal.

7. The multilayer printed circuit board according to Claim 4, wherein the one or more auxiliary connectors comprise a second auxiliary connector, and a second flange of the second auxiliary connector and a flange interconnector connected therewith are arranged on the top surface of the top substrate layer; and
wherein the flange interconnector connected with the second flange of the second auxiliary connector is also connected to a first flange of a corresponding pin holder, thereby electrically coupling the corresponding pin holder with the second auxiliary connector.

8. The multilayer printed circuit board according to Claim 7, wherein the second flange of the second auxiliary connector, a corresponding flange interconnector, and the first flange of the corresponding pin holder connected with each other are integrally formed by a same layer of metal.

9. The multilayer printed circuit board according to Claim 1, further comprising:
one or more second interconnection structures embedded in the multilayer substrate, each of which is connected between at least two die contacts for electrically coupling the at least two die contacts.

10. The multilayer printed circuit board according to Claim 9, wherein at least a portion of the one or more first interconnection structures, the one or more second interconnection structures and/or the one or more die contacts are formed by a thick copper embedding process.

11. The multilayer printed circuit board according to Claim 1, further comprising:
one or more buried spacers, each of which extends from a bottom surface of the top substrate layer through the one or more core substrate layers and the bottom substrate layer and extends beyond the bottom surface of the bottom substrate layer by a first length;
wherein the first length depends on a thickness of the one or more semiconductor dies.

12. The multilayer printed circuit board according to Claim 11, wherein the first length is equal to a sum of the thickness of the one or more semiconductor dies and a thickness of a die attachment layer, and the die attachment layer is used for attaching the one or more semiconductor dies and the multilayer printed circuit board together.

13. The multilayer printed circuit board according to Claim 1, further comprising:
a negative temperature coefficient contact embedded in the multilayer substrate, which is exposed from an opening arranged at center of the bottom substrate layer for coupling to a negative temperature coefficient sensor.

14. The multilayer printed circuit board according to Claim 1, wherein the one or more die contacts comprises a thick copper contact and/or a thin copper contact; and
wherein the one or more die contacts are used as one or more of the following: a gate-substrate contact, a source-substrate contact, a gate pad contact, and/or a source pad contact.

15. A power module comprising:
a bearing substrate;
one or more semiconductor dies attached onto the bearing substrate;
a multilayer printed circuit board comprising:
a multilayer substrate comprising a bottom substrate layer, one or more core substrate layers, and a top substrate layer stacked in sequence, wherein each of substrate layers is made of an insulating material;
one or more pin holders embedded in the multilayer substrate, each of which has an end exposed from a top surface of the top substrate layer for plugging one or more pins into the one or more pin holders;
one or more die contacts embedded in the multilayer substrate, each of which has an end exposed from a bottom surface of the bottom substrate layer for being electrically coupled with a contact of the one or more semiconductor dies; and
one or more first interconnection structures embedded in the multilayer substrate, each of which is connected between and electrically couples a corresponding pin holder and a corresponding die contact;
wherein the multilayer printed circuit board is attached onto the one or more semiconductor dies and electrically coupled with the one or more semiconductor dies through the one or more die contacts of the multilayer printed circuit board;
an enclosure enclosing the bearing substrate, the one or more semiconductor dies and the multilayer printed circuit board; and
one or more pins plugged into the one or more pin holders in the multilayer printed circuit board and exposed from one side of the enclosure.

16. The power module of claim 15, wherein each of the one or more pins comprises:
a rod-shaped body having a first end which is pointed and is adapted to be plugged into a pin holder, and a second end which comprises an elastic part and is adapted to be plugged into a through hole; and
a stopper arranged at a position at a certain distance from the first end of the rod-shaped body and protruding laterally relative to the rod-shaped body;
wherein when the first end of one of the one or more pins is plugged into one of the one or more pin holders, the stopper leans against and on top of a first flange of the pin holder.

17. A method for interconnecting one or more pins and one or more semiconductor dies, the method comprising:
attaching the one or more semiconductor dies onto a bearing substrate;
attaching a multilayer printed circuit board onto the one or more semiconductor dies, the multilayer printed circuit board comprising:
a multilayer substrate comprising a bottom substrate layer, one or more core substrate layers, and a top substrate layer stacked in sequence, wherein each of substrate layers is made of an insulating material;
one or more pin holders embedded in the multilayer substrate, each of which has an end exposed from a top surface of the top substrate layer for plugging one or more pins into the one or more pin holders;
one or more die contacts embedded in the multilayer substrate, each of which has an end exposed from a bottom surface of the bottom substrate layer for being electrically coupled with a contact of the one or more semiconductor dies; and
one or more first interconnection structures embedded in the multilayer substrate, each of which is connected between and electrically couples a corresponding pin holder and a corresponding die contact;
plugging the one or more pins into the one or more pin holders in the multilayer printed circuit board; and
enclosing the bearing substrate, the one or more semiconductor dies and the multilayer printed circuit board with an insulating material to form an enclosure.

18. The method of Claim 17, wherein attaching the multilayer printed circuit board onto the one or more semiconductor dies comprises:
coating an attachment material on contacts of the one or more semiconductor dies;
placing the multilayer printed circuit board on the one or more semiconductor dies so that contacts of a bottom substrate layer of the multilayer printed circuit board and the contacts of the one or more semiconductor dies contact each other via the attachment material; and
performing a sintering process, a welding process and/or a curing process to cure the attachment material.
